# EUROPEAN PATENT SPECIFICATION

(11) **EP 1 005 166 B1**
(45) Date of publication and mention of the grant of the patent: **16.02.2005**
(21) Application number: 99309397.0
(22) Date of filing: 24.11.1999
(51) Int. Cl.: H03L 7/113, G01R 23/02

(54) **Method for detecting frequency of digital phase locked loop**
Verfahren zur Erfassung der Frequenz in einem digitalen Phasenregelkreis
Procédé de détection de fréquence dans une boucle à verrouillage de phase numérique

(30) Priority: 26.11.1998 KR 9850947
(43) Date of publication of application: 31.05.2000
(73) Proprietor: SAMSUNG ELECTRONICS CO., LTD., Suwon-City, Kyungki-do (KR)
(72) Inventor: Park, Hyun-Soo, 119-312, Hanshin Apt., Seoul (KR); Shim, Jae-Seong, Seoul (KR); Won, Yong-Kwang, Kyungkido (KR)
(74) Representative: Chugg, David John

(56) References cited:
- EP-A- 0 342 736
- EP-A- 0 544 358
- EP-A- 0 853 386
- US-A- 5 416 809
- US-A- 5 841 323

## Description

The present invention relates to a method for detecting frequency of a digital phase locked loop in an optical disc, and more particularly, to a digital phase locked loop frequency detection method in which a low clock frequency is used in a digital phase locked loop, to thus obtain a high resolution.

A general reproduction apparatus for an optical disc such as a compact disc (CD) or a digital versatile disc (DVD) requires a process of being synchronized with a reproduction signal. A circuit for performing such a process is called a phase locked loop.

EP 0 544,358 discloses a phased locked loop with frequency deviation detector and decoder circuit comprising such a phased locked loop. EP 342,736 discloses a phased-locked-loop circuit and bit-detection arrangement comprising such a phase-locked-loop circuit.

A digital phase locked loop (PLL) includes a frequency detection block, a charge pump control block, a charge pump block, a phase detection block, a frequency divider and a voltage controlled oscillator (referred to as VCO). Here, the charge pump control block performs pulse width modulation of a frequency detection error. The charge pump block generates a current according to the pulse width modulated frequency detection error. The phase locked loop produces a VCO clock signal oscillating at a constant frequency with respect to an input signal, and then varies the frequency of the signal, to be synchronized with the input signal. However, since only a phase control restricts a control, a difference between an oscillation signal and the frequency of the input signal is calculated to perform a frequency tracking. Then, if the frequency becomes close to a frequency band, a phase control is performed. At this time, in order to heighten the resolution and accuracy of the frequency tracking, a clock whose frequency is at least double that of a reference clock by using a frequency divider is used to count a binary signal, to thereby perform frequency detection.

Thus since higher frequency clocks are required to achieve the desired resolution and to detect frequency, than the frequency of an actually required system clock signal according to conventional art, frequency detection being performed at the state where a high-frequency signal is used. However, it is difficult to generate clock frequency of four times or more according to the current technological status. Also, since analog-to-digital conversion speed limits allowable clock frequency, in the case of the digital phase locked loop, a frequency higher than that of a reference clock frequency cannot be used.

With a view to solve or reduce the above problems, it is an aim of embodiments of the present invention to provide a frequency detection method in a digital phase locked loop which can enhance resolution in detecting a reference signal frequency with only reference clock frequency without heightening frequency of a reference clock signal.

According to a first aspect of the present invention, there is provided a frequency detection method in a phase locked loop, the frequency detection method comprising the steps of: (a) detecting an edge point of an input signal; (b) sampling a point previous to and following the detected edge point of the input signal at a predetermined frequency; (c) counting the number of reference clock signals between the detected edge point and a sample which is positioned previously; (d) adding a previous frequency count value obtained from the previous sample and an interval of time corresponding to the frequency count value to obtain a frequency count value at the edge point; and (e) comparing the obtained frequency count value with a predetermined reference value, to adjust the frequency according to the comparison result.

Preferably, the input signals are sampled at frequency of said reference clock signal in said step (b).

Preferably, said step (d) comprises the sub-steps of: (d1) calculating an interval of time from the prior to-the-edge-point sample data to the edge point; (d2) calculating an interval of time from the edge point to post to-the-edge-point sample data; and (d3) adding the frequency count value up to the edge point and the interval of time obtained in step (d1), which is a frequency count value at the edge point.

Preferably, frequency of a reference signal is counted in said step (d) at a newly starting frequency count value using the calculation value obtained in step (d2).

Preferably, data between two samples which are obtained prior to and past the edge point, on the basis of the edge point is linear.

For a better understanding of the invention, and to show how embodiments of the same may be carried into effect, reference will now be made, by way of example, to the accompanying diagrammatic drawings in which:
Figure 1 is a timing diagram showing a sync pattern for a CD;
Figure 2 is a block diagram showing a frequency detection apparatus in a digital phase locked loop circuit adopting a frequency detection method according to the present invention;
Figure 3 is a view for explaining an algorithm embodying the method of the present invention; and
Figure 4 is a graphical view for explaining an embodiment of the present invention which uses the Figure 3 algorithm.

A preferred embodiment of the present invention will be described with reference to the accompanying drawings.

In order to detect frequency of an input signal, it should be checked whether frequency of a current reference signal such as an eight to fourteen modulation (EFM) signal is high or low. Tracking of frequency means that a frequency value is changed to synchronize frequency of a voltage controlled oscillator (VCO) with a reference signal (EFM signal) accurately. The reference signal (EFM signal) is integer times reference clock (T). In case of a compact disc (CD), the maximum frequency component of a signal configured in a non-return-to-zero form is 3T and the minimum frequency component is 11T. In case of a digital versatile disc (DVD), the maximum frequency component is 3T and the minimum frequency component is 14T, in which 11T, 12T and 13T do not exist between the maximum frequency component and the minimum frequency component.

Here, 11T or 14T is called a frame sync pattern. The CD has a structure which includes an 11T signal every 588T while the DVD has a structure which includes a 14T signal every 1488T.

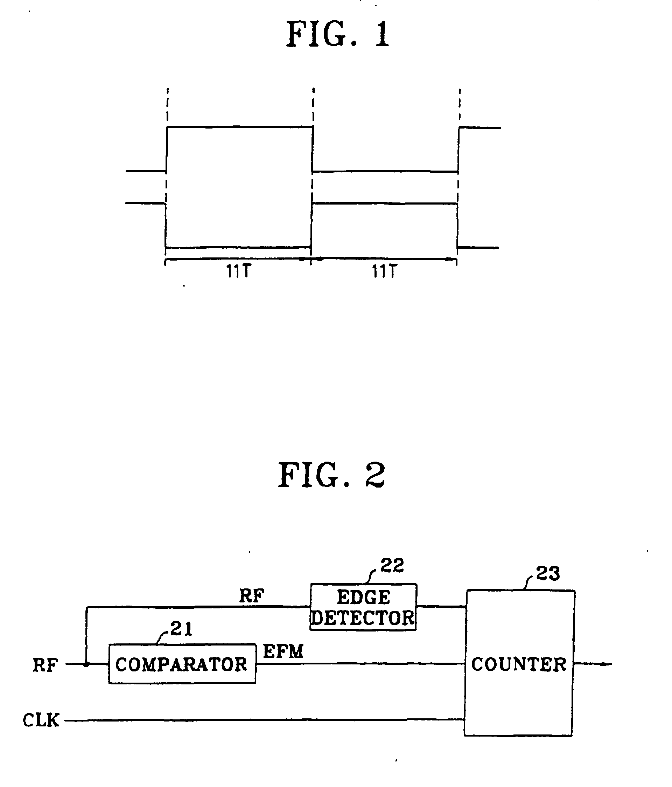

A sync pattern is used for knowing how far a VCO frequency is distant from a reference signal (EFM signal). A normal DVD has the lowest frequency component of 14T. Here, if a phase locked loop is synchronized, the VCO clock is counted by 14T. Also, the DVD has one sync pattern while the CD has two sync patterns as shown in Figure 1.

Thus, a single algorithm is applied to both CDs and DVDs, any one sync pattern of a high interval or a low interval in a reference signal should be selected. Accordingly, VCO oscillating clock is counted at a high interval or a low interval from every edge of the reference signal. A frequency difference is detected on the basis of how much a counted value at maximum for a certain period differs from 11T or 14T. In general, in order to enhance resolution, frequency two times the oscillating frequency is used for counting. Then, since 11T or 14T is counted as 22T or 28T, to thus detect a frequency difference precisely in double. To further enhance resolution, a frequency n times higher than the oscillating frequency is used for counting, which enables n times accurate frequency tracking to be performed. However, since an allowable frequency band is limited in the actual circuit, it is difficult to use oscillating frequency of two times or more. Thus, although high oscillating frequency is not used, values of the data sampled by analog to digital conversion are used, to accurately see whether a sign of data is changed at which point within one period.

Figure 2 is a block diagram showing a frequency detection apparatus in a digital phase locked loop circuit according to the present invention. In the Figure 2 apparatus, a radio frequency (RF) signal read from an optical disc (not shown) is received by a comparator 21 and an edge detector 22. The comparator 21 binarizes the input RF signal and outputs a reference signal (EFM signal) to a counter 23. The edge detector 22 outputs an edge detection signal to the counter 23 every point where a sign of the input RF signal is changed on the basis of reference voltage. The counter 23 receives a clock signal (CLK) and counts how many clock signals exist in the reference signal output from the comparator 21, according to the edge detection result of the edge detector 22.

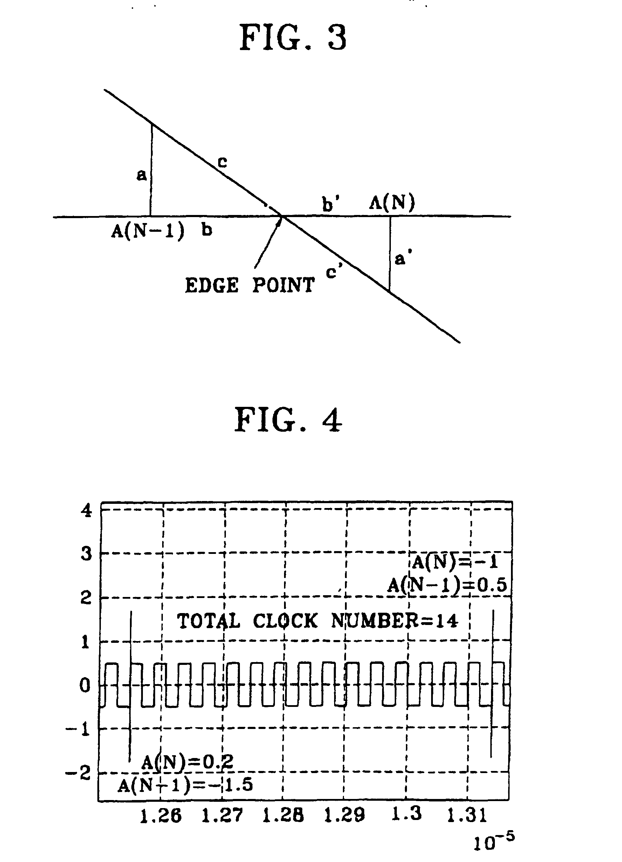

The detailed operation of the counter 23 of Figure 2 will be described below with reference to Figures 3 and 4.

Figure 3 is a view for explaining a basic algorithm embodying the method of the present invention.

It is assumed that data varies in a linear fashion between two sample points data which have been obtained by sampling RF signals at a predetermined frequency via an analog-to-digital converter (not shown). Accordingly, the data appears as shown in Figure 3.

In Figure 3, A(N-1) is the (N-1)th sample data, and A(N) is the Nth sample data. Sample values at the two sample points A(N-1) and A(N) are "a" and "a'", respectively. In Figure 3, it can be seen that a triangle abc and a triangle a'b'c' are similar. Thus, an equation a:b:c=a':b':c'; is established between three sides corresponding to each other. Thus, an interval of time between the two samples is represented as b-b'. If the sample values of a and a' are known, b and b' can be obtained by the following equations.$\text{b=a/(a+a')(b+b')}$$\text{b'=a'/(a+a')(b+b')}$

Here, a, a', b and b' are all absolute values, and b+b' is 1.

Thus, if a point at which the sign of the sampled data is changed is an edge point, a value of b is added to a count value counted up to the present at the edge point and the added result is output. Then, if a newly starting counter starts from a value of b', a frequency value can be tracked by an accurate value although only clock frequency is used. That is, it can be seen that a frequency count value=a previous frequency value+b and a newly count value=b'.

Figure 4 is a graphical view for explaining an embodiment of the present invention which uses the Figure 3 algorithm.

Assuming that values of sample data A(N) and A(N-1) are 0.2 and 1.5 at the first edge point, respectively the frequency count value is obtained by the following equation.

Frequency count value=Previous frequency count value+1.5/(0.2+1.5).

Here, a newly starting frequency count value of the counter 23 becomes 0.2/(0.2+1.5)=0.1176.

Assuming that values of sample data A(N) and A(N-1) are -1 and 0.5 at the second edge point, respectively, the frequency count value is obtained by the following equation.

Frequency count value=0.1176+0.5/(0.5+1)= 0.4509.

Here, a newly starting frequency count value of the counter 23 becomes 1/(0.5+1)=0.6667.

Thus, in the case of the Figure 4 waveform, the output value of the frequency detection is 14.4509, of which oscillating frequency is higher than 14T. Accordingly, it is obvious that oscillating frequency of the next step should be lowered to keep synchronization.

As described above, the present invention can detect frequency having high resolution with only reference clock frequency without heightening frequency of a reference clock signal, to thereby enhance quality of data.

## Claims

1. A frequency detection method in a digital phase locked loop, the frequency detection method comprising the steps of:
(a) detecting an edge point of an input signal;
(b) sampling a point previous to and following the detected edge point of the input signal at a predetermined frequency;
(c) counting the number of reference clock signals between the detected edge point and a previous sample which is positioned previously;
(d) adding a previous frequency count value obtained from the previous sample and an interval of time corresponding to the frequency count value to obtain a frequency count value at the edge point; and
(e) comparing the obtained frequency count value with a predetermined reference value, to adjust the frequency according to the comparison result.

2. The frequency detection method of claim 1, wherein the input signals are sampled at frequency of said reference clock signal in said step (b).

3. The frequency detection method of claim 1, wherein said step (d) comprises the sub-steps of:
(d1) calculating an interval of time from the prior to-the-edge-point sample data to the edge point;
(d2) calculating an interval of time from the edge point to post to-the-edge-point sample data; and
(d3) adding the frequency count value up to the edge point and the interval of time obtained in step (d1), which is a frequency count value at the edge point.

4. The frequency detection method of claim 3, wherein frequency of a reference signal is counted in said step (d) at a newly starting frequency count value using the calculation value obtained in step (d2).

5. The frequency detection method of claim 1, wherein data between two samples which are obtained prior to and past the edge point, on the basis of the edge point is linear.

## Patentansprüche

1. Frequenzerfassungsverfahren in einem digitalen Phasenregelkreis, wobei das Frequenzerfassungsverfahren die folgenden Schritte umfasst:
a) Erfassen eines Flankenpunktes eines Eingangssignals;
b) Abtasten eines Punktes vor und nach dem erfassten Flankenpunkt des Eingangssignals mit einer vorgegebenen Frequenz;
c) Zählen der Anzahl von Bezugstaktsignalen zwischen dem erfassten Flankenpunkt und einer vorangehenden Abtastung, die davor angeordnet ist;
d) Addieren eines vorangehenden Frequenzzählwertes, der aus der vorangehenden Abtastung ermittelt wurde, und eines Zeitintervalls, das dem Frequenzzählwert entspricht, um einen Frequenzzählwert an dem Flankenpunkt zu ermitteln; und
e) Vergleichen des ermittelten Frequenzzählwertes mit einem vorgegebenen Bezugswert, um die Frequenz entsprechend dem Vergleichsergebnis einzustellen.

2. Frequenzerfassungsverfahren nach Anspruch 1, wobei die Eingangssignale in dem Schritt b) mit der Frequenz des Bezugstaktsignals abgetastet werden.

3. Frequenzerfassungsverfahren nach Anspruch 1, wobei der Schritt d) die folgenden Teilschritte umfasst:
d1) Berechnen eines Zeitintervalls von den Daten der Abtastung vor dem Flankenpunkt bis zu dem Flankenpunkt;
d2) Berechnen eines Zeitintervalls von dem Flankenpunkt bis zu Daten der Abtastung nach dem Flankenpunkt; und
d3) Addieren des Frequenzzählwertes bis zu dem Flankenpunkt und des in Schritt d1) ermittelten Zeitintervalls, woraus sich ein Frequenzzählwert an dem Flankenpunkt ergibt.

4. Frequenzerfassungsverfahren nach Anspruch 3, wobei die Frequenz eines Bezugssignals in dem Schritt d) bei einem neu beginnenden Frequenzzählwert unter Verwendung des in Schritt d2) ermittelten Berechnungswertes gezählt wird.

5. Frequenzerfassungsverfahren nach Anspruch 1, wobei Daten zwischen zwei Abtastungen, die vor und nach dem Flankenpunkt ermittelt werden, auf Basis des Flankenpunktes linear sind.

## Revendications

1. Procédé de détection de fréquence dans une boucle à verrouillage de phase numérique, le procédé de détection de fréquence comprenant les étapes consistant à:
(a) détecter un point de flanc d'un signal d'entrée;
(b) échantillonner un point suivant le point détecté de flanc du signal d'entrée à une fréquence prédéterminée;
(c) compter le nombre de signaux d'horloge de référence entre le point de flanc détecté et un échantillon précédent qui est positionné précédemment;
(d) ajouter une valeur de comptage de fréquence précédente obtenue à partir de l'échantillon précédent et d'un intervalle de temps correspondant à la valeur de comptage de fréquence pour l'obtention d'une valeur de comptage de fréquence au niveau du point de flanc; et
(e) comparer la valeur de comptage de fréquence obtenue à une valeur de référence prédéterminée pour ajuster la fréquence en fonction du résultat de la comparaison.

2. Procédé de détection de fréquence selon la revendication 1, dans lequel les signaux d'entrée sont échantillonnés à une fréquence dudit signal d'horloge de référence lors de ladite étape (b).

3. Procédé de détection de fréquence selon la revendication 1, dans lequel ladite étape (d) comprend les sous-étapes consistant à:
(d1) calculer un intervalle de temps depuis la donnée d'échantillon avant le point de flanc jusqu'au point de flanc;
(d2) calculer un intervalle de temps depuis le point de flanc jusqu'à la donnée échantillon après le point de flanc; et
(d3) additionner la valeur de comptage de fréquence jusqu'au point de flanc et l'intervalle de temps obtenu lors du pas (d1), qui est une valeur de comptage de fréquence au niveau du point de flanc.

4. Procédé de détection de fréquence selon la revendication 3, selon lequel la fréquence d'un signal de référence est comptée lors dudit pas (d1) à une nouvelle valeur de comptage de fréquence de départ en utilisant la valeur de calcul obtenue lors du pas (d2).

5. Procédé de détection de fréquence selon la revendication 1, selon lequel des données entre deux échantillons, qui sont obtenues avant et après le point de flanc, sur la base du point de flanc sont linéaires.
